# EUROPEAN PATENT APPLICATION

(11) **EP 3 910 681 A1**
(43) Date of publication of application: **17.11.2021**
(21) Application number: 21173159.1
(22) Date of filing: 10.05.2021
(51) Int. Cl.: H01L 27/32, H01L 51/52

(54) **DISPLAY APPARATUS AND METHOD OF MANUFACTURING THE SAME**

(30) Priority: 15.05.2020 KR 20200058445
(71) Applicant: Samsung Display Co., Ltd., Yongin-si, Gyeonggi-Do 17113 (KR)
(72) Inventor: KIM, Jiyoon, 17113 Yongin-si (KR); KIM, Yoolguk, 17113 Yongin-si (KR); KOO, Youngmo, 17113 Yongin-si (KR)
(74) Representative: Shearman, James Ward

(57) **Abstract**

A display apparatus includes a substrate, a pixel circuit layer having at least one thin-film transistor on the substrate, a first layer disposed on the pixel circuit layer and having a first opening, and a display element disposed in the first opening and including a first electrode, an emission layer, and a second electrode, which are sequentially stacked. The first electrode extends from an inner surface of the first layer defining the first opening along an upper surface of the first layer, and the emission layer extends on the first electrode along the inner surface of the first layer.

## Description

### BACKGROUND

### FIELD

Implementations of the invention relate generally to a display apparatus and, more specifically, to a display apparatus with improved visibility and lifespan of a display element and a method of manufacturing the display apparatus.

### Discussion of the Background

As the information society has developed, the demand for display apparatuses for displaying images in various forms has increased. Display apparatuses have rapidly changed from bulky cathode ray tubes (CRTs) to slim light and large-scale flat panel display devices (FPDs). Examples of FPDs include a liquid crystal display device (LCD), a plasma display panel (PDP), an organic light-emitting display device (OLED), and an electrophoretic display device (EPD).

Among display apparatuses, the OLED may include an organic light-emitting diode as a display element, which includes an opposite electrode, a pixel electrode, and an emission layer. When a voltage is applied to the opposite electrode and the pixel electrode, visible light may be emitted from the emission layer. The emission layer may be formed by discharging ink containing a light-emitting material onto the pixel electrode.

The above information disclosed in this Background section is only for understanding of the background of the inventive concepts, and, therefore, it may contain information that does not constitute prior art.

### SUMMARY

Display apparatus constructed according to the principles and implementations of the invention and methods of manufacturing the same according to the principles and implementations are capable of improving the visibility and life span of a display element (e.g., an organic light-emitting diode) of the display apparatus. For example, the display element may include a first electrode extending from an inner surface of a first layer along an upper surface of the first layer, and an emission layer extending along the inner surface of the first layer on the first electrode.

Additional features of the inventive concepts will be set forth in the description which follows, and in part will be apparent from the description, or may be learned by practice of the inventive concepts.

According to one aspect of the invention, a display apparatus includes a substrate, a pixel circuit layer having at least one thin-film transistor on the substrate, a first layer disposed on the pixel circuit layer and having a first opening, and a display element disposed in the first opening and including a first electrode, an emission layer, and a second electrode, which are sequentially stacked. The first electrode extends from an inner surface of the first layer defining the first opening along an upper surface of the first layer, and the emission layer extends on the first electrode along the inner surface of the first layer.

The display apparatus may further include a second layer covering an end portion of the first electrode and having a second opening overlapping the first opening, the second layer may include an inner surface defining the second opening, and a first angle between the upper surface of the substrate and the inner surface of the first layer may be smaller than a second angle between an upper surface of the substrate and the inner surface of the second layer.

The first electrode may extend between the first layer and the second layer.

The emission layer may extend along the inner surface of the second layer.

An upper surface of the second layer may have liquid repellency.

The second layer may include a fluorine resin.

The second layer may include a negative photoresist, and the first layer may include a positive photoresist.

The second electrode may cover the emission layer and the second layer.

The second electrode may extend on the emission layer along the inner surface of the first layer.

The first angle between the upper surface of the substrate and the inner surface of the first layer may be about 30° or less.

The display apparatus may further include a connection electrode between the pixel circuit layer and the display element, and the first electrode may be electrically connected to the connection electrode.

The first layer may further include a first bank layer having a connection opening spaced apart from the first opening, the pixel circuit layer may further include a planarization layer covering the at least one thin-film transistor and including a contact hole exposing the at least one thin-film transistor, and the connection opening may be connected to the contact hole.

The first electrode may extend from the upper surface of the first layer (*e.g.* first bank layer) to the connection opening.

The first layer may include a first area having a first thickness, and a second area having a second thickness different from the first thickness.

According to another aspect of the invention, a display apparatus includes a substrate, a pixel circuit layer having at least one thin-film transistor on the substrate, a first layer disposed on the pixel circuit layer and having a first opening, a display element disposed in the first opening and including a first electrode, an emission layer, and a second electrode, which are sequentially stacked, and a second layer covering an end portion of the first electrode and having a second opening corresponding to the first opening, wherein the first electrode extends from an inner surface of the first layer defining the first opening along an upper surface of the first layer, the emission layer extends on the first electrode along the inner surface of the first layer, a first angle between the inner surface of the first layer and an upper surface of the substrate is about 30° or less, and the second electrode covers the emission layer and the second layer.

The first electrode may extend between the first layer and the second layer.

The second layer may include a second bank layer having an inner surface defining the second opening, and a second angle between the upper surface of the substrate and the inner surface of the second bank layer may be greater than the first angle.

The first layer may include a positive photoresist, and the second layer may include a fluorine resin or a negative photoresist.

An upper surface of the second layer may have liquid repellency.

According to still another aspect of the invention, a method of manufacturing a display apparatus includes the steps of: forming a pixel circuit layer having at least one thin-film transistor on the substrate, forming a first layer on the pixel circuit layer, the first layer having a first opening, forming a first electrode in the first opening, forming a second layer on the first layer, the second layer having a second opening, and forming an emission layer by discharging ink including a light-emitting material onto the first electrode. An upper surface of the second layer has liquid repellency.

The step of forming the first layer may include the steps of: forming a first photoresist layer on the pixel circuit layer, light-exposing a first area of the first photoresist layer, and forming the first opening in the first area. The step of forming the second layer may include the steps of: forming a second photoresist layer on the first layer and the first electrode, light-exposing a second area of the second photoresist layer arranged on an upper surface of the first layer, and forming the second opening on the first opening.

The first layer may include a first bank layer having an inner surface defining the first opening, the second layer may include a second bank layer having an inner surface defining the second opening, and a first angle between the upper surface of the substrate and the inner surface of the first layer (*e.g.* first bank layer) may be smaller than a second angle between an upper surface of the substrate and the inner surface of the second layer (*e.g.* second bank layer).

In the step of forming the first electrode, the first electrode may extend from the inner surface of the first layer (*e.g.* first bank layer) to an upper surface of the first layer (*e.g.* first bank layer).

In the step of forming the emission layer, the emission layer may be formed on the first electrode along the inner surface of the first layer (*e.g.* first bank layer).

The step of forming the second layer may include the steps of providing a molding material including a fluorine resin to a mold, and extruding the molding material on an upper surface of the first layer.

The step of forming the second layer may include the steps of forming a preliminary layer including a fluorine resin on the first electrode and the first layer, and irradiating the preliminary layer with an excimer laser.

The method may further include the step of forming a second electrode covering the emission layer and the second layer.

The step of forming the first layer may include the steps of forming a first area having a first thickness, and forming a second area having a second thickness different from the first thickness.

The method may further include the step of supplying at least one of oxygen and ozone to the first electrode.

At least some of the above and other features of the invention are set out in the claims.

It is to be understood that both the foregoing general description and the following detailed description are explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a schematic perspective view of a display apparatus constructed according to the principles of the invention.
FIG. 2 is an equivalent circuit diagram of a representative pixel included in the display apparatus of FIG. 1.
FIG. 3A is a schematic cross-sectional view of an embodiment of the display apparatus of FIG. 1
FIG. 3B is a schematic cross-sectional view of another embodiment of the display apparatus of FIG. 1.
FIGS. 4A and 4B are cross-sectional views of first and second embodiments of a pixel that may be included in the display apparatus of FIG. 1.
FIG. 5 is a cross-sectional view of a third embodiment of a display apparatus constructed according to the principles of the invention.
FIGS. 6A to 6G are cross-sectional views sequentially illustrating a method of manufacturing a display apparatus shown in FIG. 4A.
FIG. 7 is a cross-sectional view of a fourth embodiment of a display apparatus constructed according to the principles of the invention.
FIGS. 8A and 8B are cross-sectional views illustrating a method of manufacturing a display apparatus shown in FIG. 7.
FIG. 9 is a cross-sectional view of a fifth embodiment of a display apparatus constructed according to the principles of the invention.
FIGS. 10A and 10B are cross-sectional views of a method of manufacturing a display apparatus shown in FIG. 9.
FIGS. 11 and 12 are cross-sectional views of another method of manufacturing a display apparatus shown in FIG. 9.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

A display apparatus displays an image and may be included in various electronic apparatus such as a game console, a multimedia device, or a portable mobile device such as an ultra-small personal computer (PC). A display apparatus may include a liquid crystal display, an electrophoretic display, an organic light-emitting display, an inorganic light-emitting display, a field emission display, a surface-conduction electron-emitter display, a quantum dot display, a plasma display, a cathode ray display, and the like. Hereinafter, an organic light-emitting display apparatus is described as an example of a display apparatus according to an embodiment, but various types of the display apparatuses including those described above may be used in embodiments.

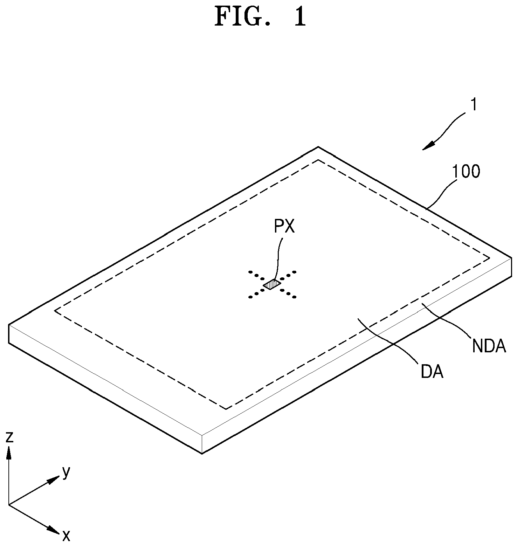

FIG. 1 is a schematic perspective view of a display apparatus 1 constructed according to the principles of the invention.

Referring to FIG. 1, the display apparatus 1 may include a display area DA and a non-display area NDA on a substrate 100.

The display area DA may display an image. A plurality of pixels PX may be arranged in the display area DA. In this case, an image may be provided by using light emitted from the pixels PX.

The non-display area NDA is an area that does not provide an image, and no pixels PX are arranged in the non-display area NDA. The non-display area NDA may surround part of or the entire display area DA. A driver or the like that provides an electric signal or power to the pixels PX may be arranged in the non-display area NDA. The non-display area NDA may include a pad portion to which an electronic element, a printed circuit board, or the like may be electrically connected.

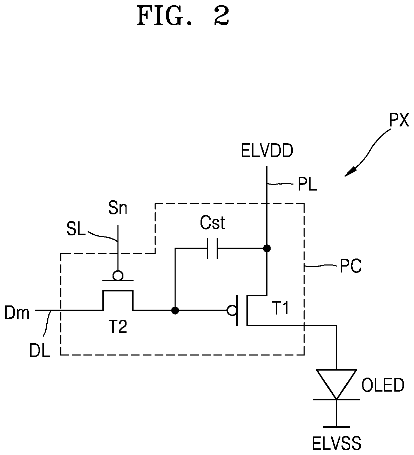

FIG. 2 is an equivalent circuit diagram of a representative pixel PX included in the display apparatus of FIG. 1.

Referring to FIG. 2, the pixel PX may include a pixel circuit PC and a display element connected to the pixel circuit PC. The display element may include an organic light-emitting diode OLED. The pixel circuit PC may include a first thin-film transistor T1, a second thin-film transistor T2, and a storage capacitor Cst. The pixel PX may emit, for example, red light, green light, or blue light through the organic light-emitting diode OLED or may emit, for example, red light, green light, blue light, or white light through the light-emitting diode OLED.

The second thin-film transistor T2 is a switching thin-film transistor that may be connected to a scan line SL and a data line DL and configured to transfer, to the first thin-film transistor T1, a data voltage or a data signal Dm input from the data line DL according to a switching voltage or a switching signal Sn input from the scan line SL. The storage capacitor Cst may be connected to the second thin-film transistor T2 and a driving voltage line PL and configured to store a voltage corresponding to a difference between a voltage received from the second thin-film transistor T2 and a first power supply voltage ELVDD supplied to the driving voltage line PL.

The first thin-film transistor T1 is a driving thin-film transistor that may be connected to the driving voltage line PL and the storage capacitor Cst and configured to control a driving current flowing from the driving voltage line PL to the organic light-emitting diode OLED according to a voltage value stored in the storage capacitor Cst. The organic light-emitting diode OLED may emit light having a certain luminance according to the driving current. An opposite electrode (e.g., a cathode) of the organic light-emitting diode OLED may be configured to receive a second power supply voltage ELVSS.

FIG. 2 illustrates that the pixel circuit PC includes two thin-film transistors and one storage capacitor, but in other embodiments, the number of thin-film transistors and the number of storage capacitors may be variously changed according to the design of the pixel circuit PC.

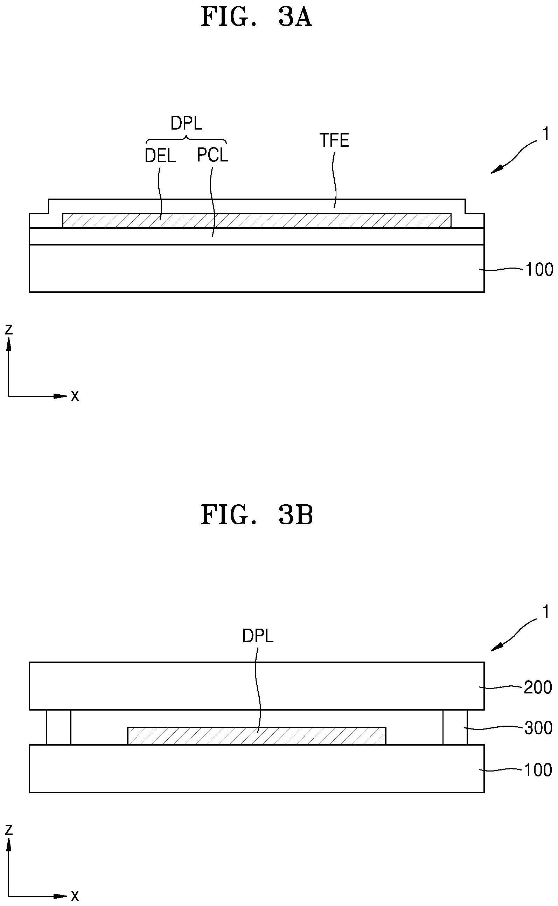

FIG. 3A is a schematic cross-sectional view of an embodiment of the display apparatus 1 of FIG. 1 and FIG. 3B is a schematic cross-sectional view of another embodiment of the display apparatus of FIG. 1.

Referring to FIG. 3A, the display apparatus 1 may include a display layer DPL and a thin-film encapsulation layer TFE on a substrate 100. The display layer DPL may include a pixel circuit layer PCL including a pixel circuit and insulating layers, and a display element layer DEL including a plurality of display elements on the pixel circuit layer PCL.

The substrate 100 may include glass or a polymer resin such as polyethersulfone, polyacrylate, polyetherimide, polyethylene naphthalate, polyethylene terephthalate, polyphenylene sulfide, polyimide, polycarbonate, cellulose triacetate (TAC), or cellulose acetate propionate.

A barrier layer may be further included between the pixel circuit layer PCL and the substrate 100. The barrier layer may prevent penetration of external foreign substances. The barrier layer may include a single layer or a multi-layer including an inorganic material such as silicon nitride (SiNₓ) or silicon oxide (SiOₓ).

The display element layer DEL may include display elements, for example, an organic light-emitting diode. The pixel circuit layer PCL may include insulating layers and a pixel circuit connected to the organic light-emitting diode. The pixel circuit layer PCL may include a plurality of transistors, a plurality of storage capacitors, and insulating layers therebetween.

The display elements may be covered with an encapsulation member such as a thin-film encapsulation layer TFE. The thin-film encapsulation layer TFE may include at least one inorganic encapsulation layer and at least one organic encapsulation layer, which cover the display element layer DEL. The at least one inorganic encapsulation layer may include at least one inorganic material selected from aluminium oxide, titanium oxide, tantalum oxide, hafnium oxide, zinc oxide, silicon oxide, silicon nitride, and silicon oxynitride. The organic encapsulation layer may include a polymer-based material. The polymer-based material may include an acryl-based resin, an epoxy-based resin, polyimide, polyethylene, and the like. In an embodiment, the organic encapsulation layer may include acrylate.

Referring to FIG. 3B, the display apparatus 1 may include a display layer DPL and an upper substrate 200 on a substrate 100. A sealing member 300 may be between the substrate 100 and the upper substrate 200. The upper substrate 200 may include a transparent member. The substrate 100 and the upper substrate 200 may be coupled to each other by the sealing member 300, such that an internal space between the substrate 100 and the upper substrate 200 is sealed. An absorbent or a filler may be located in the internal space. The sealing member 300 may include a sealant. In another embodiment, the sealing member 300 may include a material that is curable by laser. For example, the sealing member 300 may include a frit. Specifically, the sealing member 300 may include an organic sealant such as a urethane-based resin, an epoxy-based resin, or an acryl-based resin, or may include an inorganic sealant such as silicone. Examples of the urethane-based resin may include urethane acrylate. Examples of the acryl-based resin may include butyl acrylate and ethyl hexyl acrylate. The sealing member 300 may include a material that is curable by heat.

In some embodiments, the display element layer DEL may be covered with the upper substrate 200 and the sealing member 300 of FIG. 3B together with the thin-film encapsulation layer TFE of FIG. 3A.

A touch electrode layer may be arranged on the thin-film encapsulation layer TFE and/or the upper substrate 200, and an optical functional layer may be arranged on the touch electrode layer. The touch electrode layer may obtain coordinate information according to an external input, for example, a touch event. The optical functional layer may reduce reflectance of light (external light) incident from the outside toward the display apparatus 1 and/or may improve color purity of light emitted from the display apparatus 1. The optical functional layer may include a retarder and/or a polarizer. The retarder may be a film type retarder or a liquid crystal coating type retarder and may include a λ/2 retarder and/or a λ/4 retarder. The polarizer may also be a film type polarizer or a liquid crystal coating type polarizer. The film type polarizer may include a stretched synthetic resin film, and the liquid crystal coating type polarizer may include liquid crystals arranged in a certain array. The retarder and the polarizer may each further include a protective film.

In another embodiment, the optical functional layer may include a black matrix and color filters. The color filters may be arranged considering the color of light emitted from each pixel of the display apparatus 1. The color filters may each include a red, green, or blue pigment or dye. Alternatively, the color filters may each further include, in addition to the pigment or dye, a quantum dot. Alternatively, some of the color filters may not include the pigment or dye and may include scattering particles such as titanium oxide.

In another embodiment, the optical functional layer may include a destructive interference structure. The destructive interference structure may include a first reflective layer and a second reflective layer, which are arranged on different layers. First reflected light and second reflected light, which are respectively reflected from the first reflective layer and the second reflective layer, may destructively interfere with each other, such that reflectance of external light is reduced.

An adhesive member may be between the touch electrode layer and the optical functional layer. The adhesive member may be employed without limiting those commonly known in the art. The adhesive layer may include a pressure sensitive adhesive (PSA).

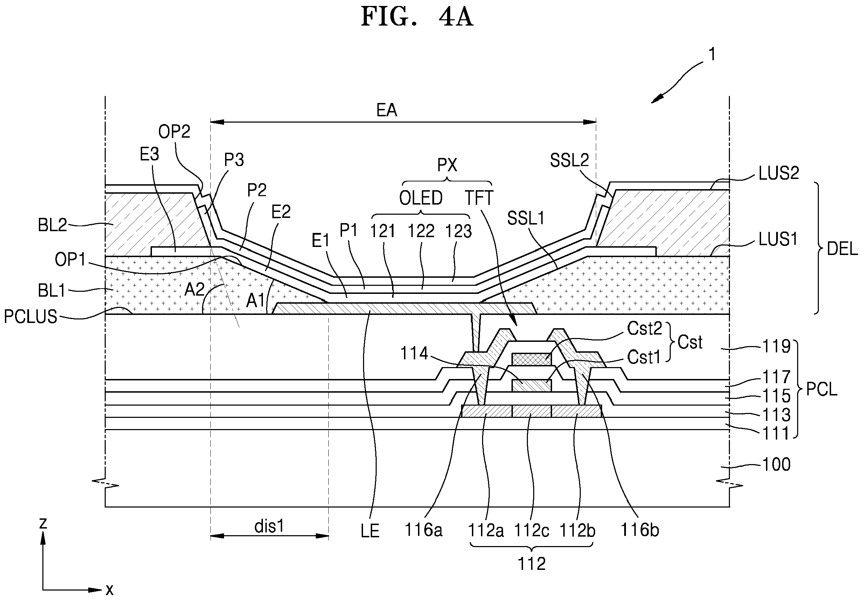

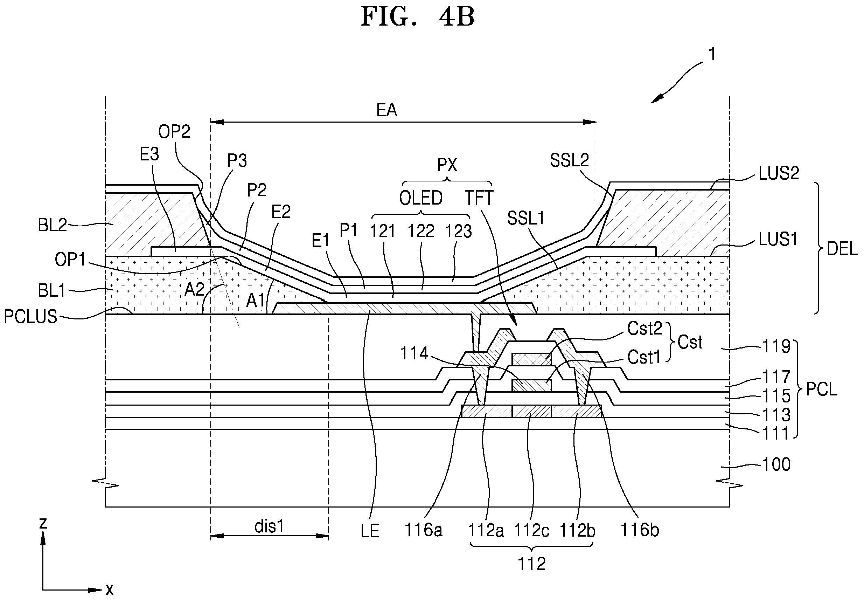

FIG. 4A is a cross-sectional view of a first embodiment of a pixel PX that may be included in the display apparatus of FIG. 1, and FIG. 4B is a cross-sectional view of a second embodiment of a pixel PX that may be included in the display apparatus of FIG. 1. In FIGS. 4A and 4B, the same reference numerals as those in FIG. 3A refer to the same members, and a repetitive description will be omitted to avoid redundancy. The embodiment of FIG. 4B is different from the embodiment of FIG. 4A in that the thickness of the third emission layer area P3 is gradually reduced toward the edge of the third emission layer area P3.

Referring to FIGS. 4A and 4B, the display apparatus may include a substrate 100, a pixel circuit layer PCL on the substrate 100, and a display element layer DEL on the pixel circuit layer PCL. The pixel circuit layer PCL may include at least one thin-film transistor TFT. The display element layer DEL may include a first layer in the form of first bank layer BL1, a second layer in the form of second bank layer BL2, and an organic light-emitting diode OLED as a display element. The organic light-emitting diode OLED may include a first electrode 121, an emission layer 122, and a second electrode 123.

The pixel circuit layer PCL may include a thin-film transistor TFT, and a buffer layer 111, a first gate insulating layer 113, a second gate insulating layer 115, an interlayer insulating layer 117, and a planarization layer 119, which are arranged under or/and above elements of the thin-film transistor TFT.

The buffer layer 111 may include an inorganic insulating material such as silicon nitride, silicon oxynitride, and silicon oxide, and may include a single layer or a multi-layer including the above-described inorganic insulating materials.

The thin-film transistor TFT may include a semiconductor layer 112, and the semiconductor layer 112 may include polysilicon. Alternatively, the semiconductor layer 112 may include amorphous silicon, semiconductor oxide, or organic semiconductor. The semiconductor layer 112 may include a channel region 112c, and a drain region 112a and a source region 112b arranged on both sides of the channel region 112c.

The gate electrode 114 may overlap the channel region 112c. The gate electrode 114 may include a low resistance metal material. The gate electrode 114 may include a conductive material such as molybdenum (Mo), aluminium (Al), copper (Cu), or titanium (Ti), and may include a single layer or a multi-layer including the above-described materials.

The first gate insulating layer 113 between the semiconductor layer 112 and the gate electrode 114 may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO).

The second gate insulating layer 115 may cover the gate electrode 114. Similarly to the first gate insulating layer 113, the second gate insulating layer 115 may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂2O₅), hafnium oxide (HfO₂), or zinc oxide (ZnO).

An upper electrode Cst2 of the storage capacitor Cst may be arranged on the second gate insulating layer 115. The upper electrode Cst2 may overlap the gate electrode 114 arranged thereunder. In this case, the gate electrode 114 and the upper electrode Cst2 overlapping each other with the second gate insulating layer 115 therebetween may form the storage capacitor Cst. That is, the gate electrode 114 may function as a lower electrode Cst1 of the storage capacitor Cst.

As such, the storage capacitor Cst may overlap the thin-film transistor TFT. In some embodiments, the storage capacitor Cst may not overlap the thin-film transistor TFT.

The upper electrode Cst2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may include a single layer or a multi-layer including the above-described materials.

The interlayer insulating layer 117 may cover the upper electrode Cst2. The interlayer insulating layer 117 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnO). The interlayer insulating layer 117 may include a single layer or a multi-layer including the above-described inorganic insulating materials.

A drain electrode 116a and a source electrode 116b may be located on the interlayer insulating layer 117. The drain electrode 116a and the source electrode 116b may be respectively connected to the drain region 112a and the source region 112b through contact holes provided in the first gate insulating layer 113, the second gate insulating layer 115, and the interlayer insulating layer 117. The drain electrode 116a and the source electrode 116b may each include a material having good conductivity. The drain electrode 116a and the source electrode 116b may each include a conductive material such as molybdenum (Mo), aluminum (Al), copper (Cu), or titanium (Ti), and may each include a single layer or a multi-layer including the above-described materials. The drain electrode 116a and the source electrode 116b may each have a multi-layered Ti/Al/Ti structure.

The planarization layer 119 may cover the thin-film transistor TFT and may include a contact hole exposing a portion of the thin-film transistor TFT. The planarization layer 119 may include an organic insulating layer. The planarization layer 119 may include an organic insulating material such as a general-purpose polymer (polymethylmethacrylate (PMMA), polystyrene (PS), etc.) a polymer derivative having a phenol-based group, an acryl-based polymer, an aryl ether-based polymer, an amide-based polymer, a fluorine-based polymer, a p-xylene-based polymer, a vinyl alcohol-based polymer, and any blends thereof.

A connection electrode LE may be arranged on the pixel circuit layer PCL. The connection electrode LE may be between the pixel circuit layer PCL and the organic light-emitting diode OLED. The connection electrode LE may be connected to the thin-film transistor TFT through the contact hole of the planarization layer 119. Specifically, the connection electrode LE may be connected to the drain electrode 116a or the source electrode 116b. Also, the connection electrode LE may be connected to the organic light-emitting diode OLED.

The connection electrode LE may include a conductive material such as molybdenum (Mo), aluminium (Al), copper (Cu), and titanium (Ti), and may include a single layer or a multi-layer including the above-described materials. The connection electrode LE may have a multi-layered Ti/Al/Ti structure. The connection electrode LE may include conductive oxide such as indium tin oxide (ITO), indium zinc oxide (IZO), zinc oxide (ZnO), indium oxide (In₂O₃), indium gallium oxide (IGO), or aluminium zinc oxide (AZO). In another embodiment, the connection electrode LE may include a reflective layer including silver (Ag), magnesium (Mg), aluminium (Al), platinum (Pt), palladium (Pd), gold (Au), nickel (Ni), neodymium (Nd), iridium (Ir), chromium (Cr), or any compounds thereof. In another embodiment, the connection electrode LE may further include a layer including ITO, IZO, ZnO, or In₂O₃ above and/or under the reflective layer. In some embodiments, the connection electrode LE may be omitted.

The first bank layer BL1 may be arranged on the pixel circuit layer PCL. The first bank layer BL1 may include a first opening OP1. Also, the first bank layer BL1 may include an inner surface SSL1 of the first bank layer BL1 defining the first opening OP1. The inner surface SSL1 of the first bank layer BL1 may have a gentle slope with respect to the upper surface of the substrate 100. In the illustrated embodiment, the first electrode 121 and the emission layer 122 may be arranged on the inner surface SSL1 of the first bank layer BL1. In order for the emission layer 122 to have a substantially constant thickness on the inner surface SSL1 of the first bank layer BL1, the inner surface SSL1 of the first bank layer BL1 has to have a gentle slope with respect to the upper surface of the substrate 100. Details thereof will be described below.

In an embodiment, a first angle A1 between an upper surface PCLUS of the pixel circuit layer PCL and the inner surface SSL1 of the first bank layer BL1 may be an acute angle. Specifically, the first angle A1 between the upper surface PCLUS of the pixel circuit layer PCL and the inner surface SSL1 of the first bank layer BL1 may be about 30° or less. In this case, the upper surface PCLUS of the pixel circuit layer PCL may face the first bank layer BL1.

Alternatively, in another embodiment, the first angle A1 between the upper surface of the substrate 100 and the inner surface SSL1 of the first bank layer BL1 may be an acute angle. Specifically, the first angle A1 between the upper surface of the substrate 100 and the inner surface SSL1 of the first bank layer BL1 may be about 30° or less. In this case, the upper surface of the substrate 100 may face the pixel circuit layer PCL.

The first bank layer BL1 may cover an end portion of the connection electrode LE, and the first opening OP1 may expose at least a portion of the connection electrode LE.

The first opening OP1 may overlap the organic light-emitting diode OLED. FIGS. 4A and 4B illustrate one first opening OP1, but in an embodiment, a plurality of first openings OP1 may be arranged in the display element layer DEL.

The first bank layer BL1 may include a photoresist, that is, a photosensitive resin. Specifically, the first bank layer BL1 may include a positive photoresist. For example, the first bank layer BL1 may include diazonaphthoquinones, maleic anhydride/norbornene copolymer, hydroxystyrene/acrylate copolymer, or methacrylate copolymer. As another example, the first bank layer BL1 may include at least one of diazonaphthoquinone (DNQ) and a novolac resin.

The pixel PX may include an organic light-emitting diode OLED and a thin-film transistor TFT. The pixel PX may emit, for example, red light, green light, or blue light through the organic light-emitting diode OLED or may emit, for example, red light, green light, blue light, or white light through the light-emitting diode OLED.

The organic light-emitting diode OLED may overlap the first opening OP1. The organic light-emitting diode OLED may include a first electrode 121, an emission layer 122, and a second electrode 123, which are sequentially stacked. In this case, the first electrode 121 may be a pixel electrode, and the second electrode 123 may be an opposite electrode.

The first electrode 121 may extend from the inner surface SSL1 of the first bank layer BL1 along an upper surface LUS1 of the first bank layer BL1. Also, the first electrode 121 may extend from the upper surface LUS1 of the first bank layer BL1. In this case, the upper surface LUS1 of the first bank layer BL1 may face the second bank layer BL2.

The first electrode 121 may include a first electrode area E1, a second electrode area E2, and a third electrode area E3. The first electrode area E1 may be arranged inside the first opening OP1. The first electrode area E1 may be arranged on the connection electrode LE and may be connected to the connection electrode LE. The second electrode area E2 may extend from the first electrode area E1. The second electrode area E2 may be arranged on the inner surface SSL1 of the first bank layer BL1. The third electrode area E3 may extend from the second electrode area E2. The third electrode area E3 may be arranged on the upper surface LUS1 of the first bank layer BL1. The third electrode area E3 may extend from the upper surface LUS1 of the first bank layer BL1.

The first electrode 121 may be connected to the thin-film transistor TFT. The first electrode 121 may be electrically connected to the thin-film transistor (TFT). For example, referring to FIG. 4A, the first electrode 121 may be connected to the thin-film transistor TFT through the connection electrode LE.

The first electrode 121 may include conductive oxide such as indium tin oxide (ITO), indium zinc oxide (IZO), zinc oxide (ZnO), indium oxide (In₂O₃), indium gallium oxide (IGO), or aluminium zinc oxide (AZO). In another embodiment, the first electrode 121 may include a reflective film including silver (Ag), magnesium (Mg), aluminium (Al), platinum (Pt), palladium (Pd), gold (Au), nickel (Ni), neodymium (Nd), iridium (Ir), chromium (Cr), or any compounds thereof. In another embodiment, the first electrode 121 may further include a layer including ITO, IZO, ZnO, or In₂O₃ above and/or under the reflective film. In some embodiments, the first electrode 121 may have a thickness of about 100 nm.

The second bank layer BL2 may be arranged on the first bank layer BL1. In this case, the second bank layer BL2 may cover the end portion of the first electrode 121. That is, the second bank layer BL2 may cover the third electrode area E3 of the first electrode 121. Therefore, the first electrode 121 may extend between the first bank layer BL1 and the second bank layer BL2. Specifically, the third electrode area E3 arranged on the upper surface LUS1 of the first bank layer BL1 may extend between the first bank layer BL1 and the second bank layer BL2. In some embodiments, the second bank layer BL2 may have a thickness of about 500 nm or less.

The second bank layer BL2 may include a second opening OP2. Also, the second bank layer BL2 may include an inner surface SSL2 of the second bank layer BL2 defining the second opening OP2. The second opening OP2 may overlap the organic light-emitting diode OLED. FIGS. 4A and 4B illustrate one second opening OP2, but in an embodiment, a plurality of second openings OP2 may be arranged in the display element layer DEL.

The second bank layer BL2 may cover the end portion of the first electrode 121, and the second opening OP2 may expose at least a portion of the first electrode 121. Specifically, the second opening OP2 may expose the first electrode area E1 and/or the second electrode area E2 of the first electrode 121.

The second opening OP2 may define an emission area EA in which light is emitted from the organic light-emitting diode OLED. For example, the width of the second opening OP2 may correspond to the width of the emission area EA. In this case, the width of the second opening OP2 may be defined as the shortest distance between the inner surfaces SSL2 of the second bank layer BL2.

The width of the second opening OP2 may be greater than the width of the first opening OP1. The width of the first opening OP1 may be defined as the shortest distance between the inner surfaces SSL1 of the first bank layer BL1. That is, at least a portion of the first bank layer BL1 may be arranged inside the second opening OP2. In this case, the first bank layer BL1 may be arranged inside the second opening OP2 by a first distance disl. For example, the first distance disl may be about 2 µm to about 3 µm in the x direction.

In an embodiment, a second angle A2 between the upper surface PCLUS of the pixel circuit layer PCL and the inner surface SSL2 of the second bank layer BL2 may be about 60° or more. In another embodiment, the second angle A2 may be defined as an angle between upper surface of the substrate 100 and the inner surface SSL2 of the second bank layer BL2. For example, the angle between the upper surface of the substrate 100 and the inner surface SSL2 of the second bank layer BL2 may be about 60° or more.

The second angle A2 between the upper surface PCLUS of the pixel circuit layer PCL and the inner surface SSL2 of the second bank layer BL2 may be greater than the first angle A1 between the upper surface PCLUS of the pixel circuit layer PCL and the inner surface SSL1 of the first bank layer BL1.

The second bank layer BL2 may include a photoresist, that is, a photosensitive resin. Specifically, the second bank layer BL2 may include a negative photoresist. For example, the second bank layer BL2 may include an epoxy-based polymer or an off-stoichiometry thiolenes (OSTE) polymer. The material of the second bank layer BL2 may be relatively higher in molecular weight than the material of the first bank layer BL1. In some embodiments, similarly to the first bank layer BL1, the second bank layer BL2 may include a positive photoresist.

The second bank layer BL2 may have liquid repellency. In particular, the upper surface LUS2 of the second bank layer BL2 may have liquid repellency. As used herein, having liquid repellency means that, during an inkjet process, a contact angle with respect to a solvent constituting an ink including a light-emitting material forming the emission layer 122 or an ink including a light-emitting material forming the emission layer 122 is about 90° or more. That is, having liquid repellency means that, during an inkjet process, a contact angle with respect to a solvent constituting an ink including a light-emitting material forming the emission layer 122 or an ink including a light-emitting material forming the emission layer 122 is relatively great. On the other hand, having liquid lyophilicity means that, during an inkjet process, a contact angle with respect to a solvent constituting an ink including a light-emitting material forming the emission layer 122 or an ink including a light-emitting material forming the emission layer 122 is relatively small.

The emission layer 122 may be arranged on the first electrode 121. On the first electrode 121, the emission layer 122 may extend along the inner surface SSL1 of the first bank layer BL1. The emission layer 122 may include a first emission layer area P1 and a second emission layer area P2. The first emission layer area P1 may be arranged on the first electrode area E1. The second emission layer area P2 may be arranged on the second electrode area E2. That is, the second emission layer area P2 may be arranged on the inner surface SSL1 of the first bank layer BL1. The emission layer 122 may further extend along the inner surface SSL2 of the second bank layer BL2. In this case, the emission layer 122 may further include a third emission layer area P3 extending from the second emission layer area P2. The third emission layer area P3 may be arranged on the inner surface SSL2 of the second bank layer BL2. In the embodiment shown in FIG. 4B, the thickness of the third emission layer area P3 may be gradually reduced toward the edge of the third emission layer area P3.

The emission layer 122 may include a high molecular weight organic material or a low molecular weight organic material, which emits light of a certain color. In this case, the emission layer 122 may be formed by discharging ink including a light-emitting material onto the first electrode 121. For example, the emission layer 122 may be formed by inkjet printing.

A first functional layer and a second functional layer may be arranged under and above the emission layer 122, respectively. For example, the first functional layer may include a hole transport layer (HTL), or may include an HTL and a hole injection layer (HIL). The second functional layer is an optional element arranged on the emission layer 122. The second functional layer may include an electron transport layer (ETL) and/or an electron injection layer (EIL). The first functional layer and/or the second functional layer may be a common layer covering the entire substrate 100, as in the second electrode 123 to be described below.

The second electrode 123 may cover the emission layer 122 and the second bank layer BL2. On the emission layer 122, the second electrode 123 may extend along the inner surface SSL1 of the first bank layer BL1. On the emission layer 122, the second electrode 123 may extend along the inner surface SSL2 of the second bank layer BL2, and the second electrode 123 may extend along the upper surface LUS2 of the second bank layer BL2.

The second electrode 123 may include a conductive material having a relatively low work function. For example, the second electrode 123 may include a (semi)transparent layer including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), or any alloys thereof. Alternatively, the second electrode 123 may further include a layer such as ITO, IZO, ZnO, or In₂O₃ on the (semi)transparent layer including the above-mentioned materials.

Also, in an embodiment, a thin-film encapsulation layer and/or an upper substrate may be arranged on the second electrode 123.

According to the principles and some embodiments of the invention, the visibility and the lifespan of the display element are improved. The first electrode 121 may extend from the inner surface SSL1 of the first bank layer BL1 along the upper surface LUS1 of the first bank layer BL1, and on the first electrode 121, the emission layer 122 may extend along the inner surface SSL1 of the first bank layer BL1. In this case, because the inner surface SSL1 of the first bank layer BL1 has a gentle slope with respect to the upper surface of the substrate 100, the thickness of the emission layer 122 may be maintained substantially constant. For example, the thickness of the emission layer 122 in the first emission layer area P1 and the thickness of the emission layer 122 in the second emission layer area P2 may be substantially constant. When the thickness of the emission layer 122 in the second emission layer area P2 is greater than the thickness of the emission layer 122 in the first emission layer area P1, light may not be extracted from the second emission layer area P2. In an embodiment, because the inner surface SSL1 of the first bank layer BL1 has a gentle slope with respect to the upper surface of the substrate 100, the thickness of the emission layer 122 may be maintained substantially constant. Because light is extracted from the first emission layer area P1 and the second emission layer area P2, the emission area EA may be expanded and the lifespan of the organic light-emitting diode OLED may be improved.

Also, in an embodiment, because light is also extracted from the emission layer 122 arranged on the inner surface SSL1 of the first bank layer BL1, the visibility may be improved. In particular, the white angle difference (WAD) may be improved.

Also, in an embodiment, because the first electrode 121 is arranged in a generally concave shape by the first bank layer BL1, the first electrode 121 may reflect light exiting laterally from the emission layer 122 in a light output direction. Therefore, the light extraction efficiency of the organic light-emitting diode OLED may be improved.

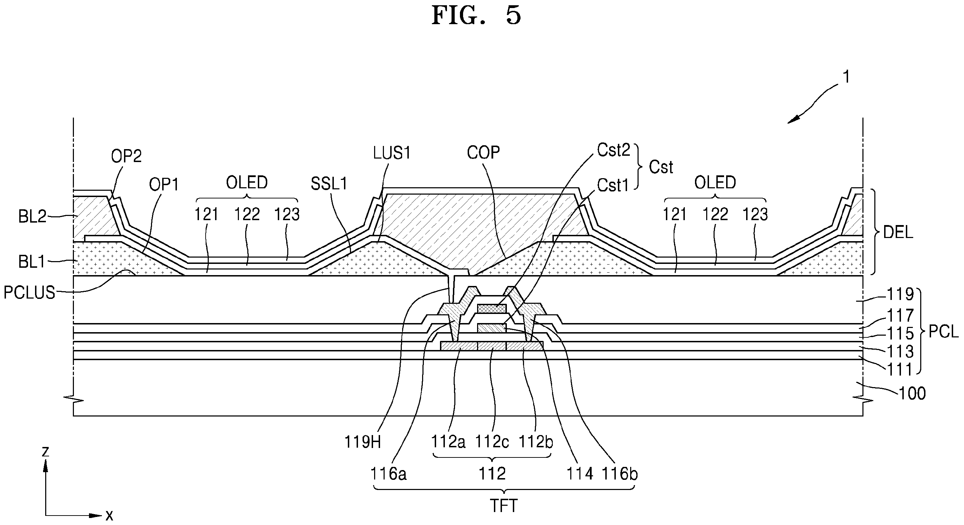

FIG. 5 is a cross-sectional view of a third embodiment of a display apparatus 1 constructed according to the principles of the invention. The embodiment of FIG. 5 is different from the embodiment of FIG. 4A in that the connection electrode LE of FIGS. 4A and 4B is omitted and the first electrode 121 is directly connected to the thin-film transistor TFT. In FIG. 5, the same reference numerals as those in FIG. 4A refer to the same members, and a repetitive description will be omitted to avoid redundancy.

Referring to FIG. 5, the display apparatus 1 may include: a substrate 100; a pixel circuit layer PCL including a thin-film transistor TFT on the substrate 100; a first bank layer BL1 arranged on the pixel circuit layer PCL and including a first opening OP1; and an organic light-emitting diode OLED arranged to correspond to the first opening OP1 and including a first electrode 121, an emission layer 122, and a second electrode 123, which are sequentially stacked. The first electrode 121 may extend from an inner surface SSL1 of the first bank layer BL1 along an upper surface LUS1 of the first bank layer BL1, and on the first electrode 121, the emission layer 122 may extend along the inner surface SSL1 of the first bank layer BL1.

In the illustrated embodiment, the first electrode 121 may be arranged on an upper surface PCLUS of the pixel circuit layer PCL. In this case, the upper surface PCLUS of the pixel circuit layer PCL may face the first bank layer BL1. The upper surface PCLUS of the pixel circuit layer PCL may be an upper surface of a planarization layer 119. In this case, the connection electrode LE of FIG. 4 may be omitted.

In the illustrated embodiment, the first bank layer BL1 may include a connection opening COP. The connection opening COP may be spaced apart from the first opening OP1. The connection opening COP may be between the adjacent first openings OP1. In this case, the connection opening COP may be connected to a contact hole 119H of the planarization layer 119. That is, the connection opening COP may be arranged on the contact hole 119H of the planarization layer 119.

The first electrode 121 may extend from the upper surface LUS1 of the first bank layer BL1 to the connection opening COP, and the first electrode 121 may be connected to a thin-film transistor TFT through the contact hole 119H of the planarization layer 119. That is, the first electrode 121 may be directly connected to the thin-film transistor TFT. In the illustrated embodiment, because the first electrode 121 is connected to the thin-film transistor TFT, it may be unnecessary to separately form a connection electrode.

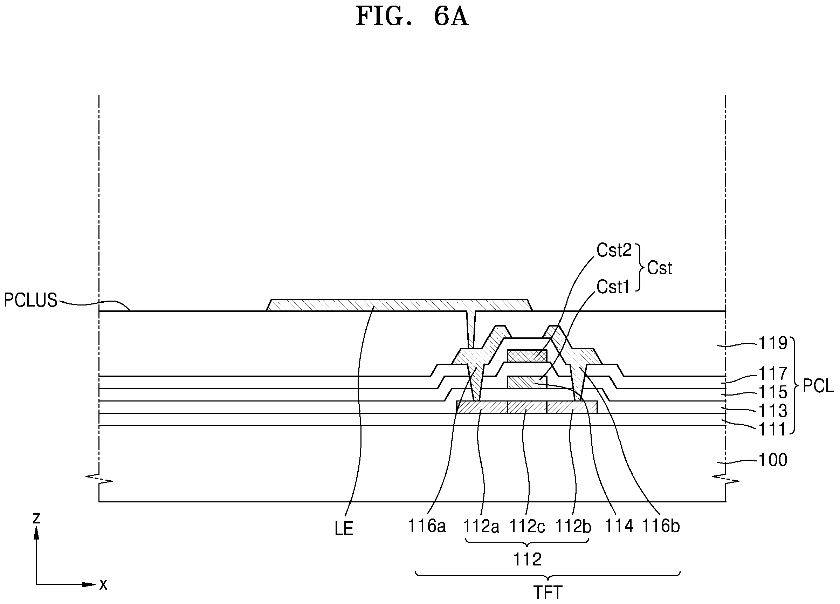

FIGS. 6A to 6G are cross-sectional views sequentially illustrating a method of manufacturing a display apparatus shown in FIG. 4A. In FIGS. 6A to 6G, the same reference numerals as those in FIG. 4A refer to the same members, and a repetitive description will be omitted to avoid redundancy.

Referring to FIG. 6A, a pixel circuit layer PCL including at least one thin-film transistor TFT may be formed on a substrate 100.

A connection electrode LE may be formed on the pixel circuit layer PCL. The connection electrode LE may be formed on an upper surface PCLUS of the pixel circuit layer PCL. In this case, the connection electrode LE may be connected to the thin-film transistor TFT through a contact hole of a planarization layer 119.

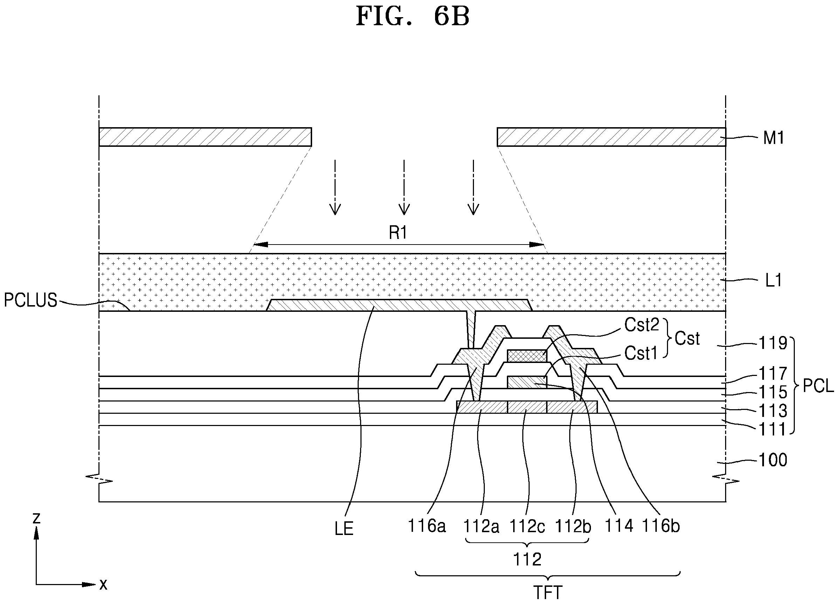

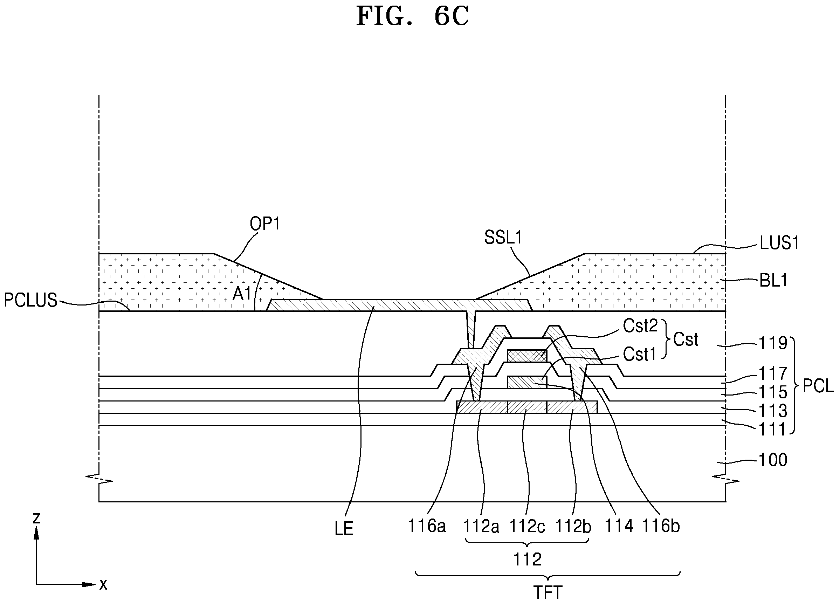

Referring to FIGS. 6B and 6C, a first photoresist layer L1 may be formed on the pixel circuit layer PCL. The first photoresist layer L1 may include a positive photoresist. The first photoresist layer L1 may be formed by applying a positive photoresist liquid to the pixel circuit layer PCL through various methods such as spin-coating, spraying, or immersion. Before the first photoresist layer L1 is applied to the upper surface of the pixel circuit layer PCL, a process of polishing the upper surface PCLUS of the pixel circuit layer PCL to which the first photoresist layer L1 is to be applied may be additionally performed.

A first exposure mask M1 may be arranged on the first photoresist layer L1. An opening of the first exposure mask M1 may overlap a first area R1. The first area R1 is an area in which a first opening is to be formed. The first area R1 may correspond to the connection electrode LE.

The first photoresist layer L1 may be exposed. In this case, the first area R1 of the first photoresist layer L1 may be exposed.

A portion of the first photoresist layer L1 may be removed through a developing process. The first photoresist layer L1 is formed by using a positive photoresist liquid. When a developing process is performed on the first photoresist layer L1, the light-exposed first area R1 of the first photoresist layer L1 may be removed. Therefore, a first opening OP1 may be formed in the first photoresist layer L1 to form a first bank layer BL1.

In an embodiment, when the connection electrode LE is formed on the pixel circuit layer PCL, the first bank layer BL1 may cover the end portion of the connection electrode LE and expose at least a portion of the connection electrode LE.

The degree of adhesion with the pixel circuit layer PCL may be increased through a curing and drying process of the first bank layer BL1. In this case, the curing and drying process may include a heat treatment process. In this case, because the first bank layer BL1 employs a positive photoresist, the inner surface SSL1 of the first bank layer BL1 may have a gentle slope with respect to the upper surface of the substrate 100 even when the heat treatment process is performed thereon.

A first angle A1 between the upper surface PCLUS of the pixel circuit layer PCL or the upper surface of the substrate 100 and the inner surface SSL1 of the first bank layer BL1 may be an acute angle. In particular, the first angle A1 between the upper surface PCLUS of the pixel circuit layer PCL or the upper surface of the substrate 100 and the inner surface SSL1 of the first bank layer BL1 may be about 30° or less.

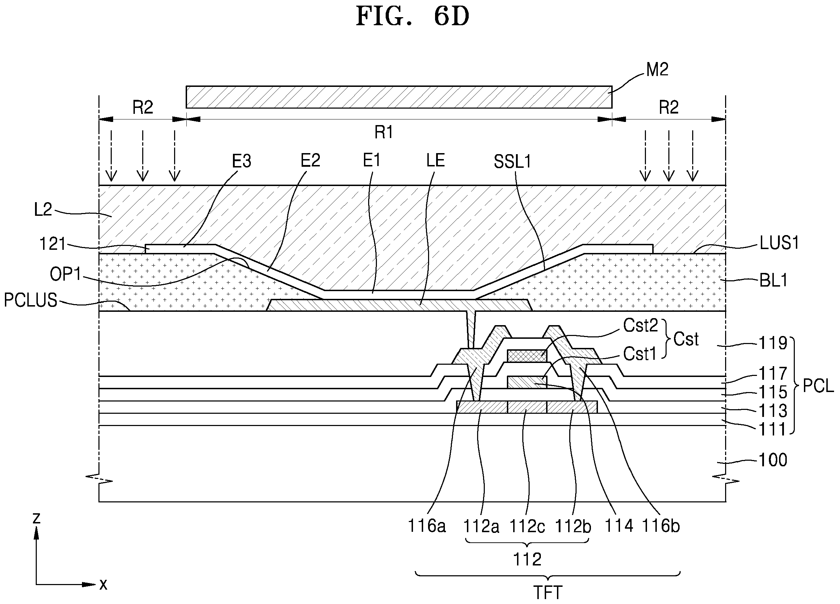

Referring to FIG. 6D, a first electrode 121 may be formed to correspond to the first opening OP1. The first electrode 121 may be formed to extend from the inner surface SSL1 of the first bank layer BL1 along the upper surface LUS1 of the first bank layer BL1. The first electrode 121 may be formed through a photolithography process.

The first electrode 121 may include a first electrode area E1, a second electrode area E2, and a third electrode area E3. The first electrode area E1 may be formed inside the first opening OP1. The first electrode area E1 may be formed on the connection electrode LE and may be connected to the connection electrode LE. The second electrode area E2 may extend from the first electrode area E1. The second electrode area E2 may be formed on the inner surface SSL1 of the first bank layer BL1. The third electrode area E3 may extend from the second electrode area E2. The third electrode area E3 may be formed on the upper surface LUS 1 of the first bank layer BL1. The third electrode area E3 may extend from the upper surface LUS 1 of the first bank layer BL1.

A second photoresist layer L2 may be formed on the first bank layer BL1 and the first electrode 121. The second photoresist layer L2 may include a negative photoresist. The second photoresist layer L2 may be formed by applying a negative photoresist liquid to the first bank layer BL1 and the first electrode 121 through various methods such as spin-coating, spraying, or immersion. In some embodiments, the second photoresist layer L2 may include a positive photoresist. However, for convenience of description, a case in which the second photoresist layer L2 includes a negative photoresist will be described in detail. The method of forming the second photoresist layer L2 may be identical to or similar to the method of forming the first photoresist layer L1.

A second exposure mask M2 may be arranged on the second photoresist layer L2. An opening of the second exposure mask M2 may overlap the first bank layer BL1. The opening of the second exposure mask M2 may overlap the second area R2 of the second photoresist layer L2 corresponding to the first bank layer BL1.

The second photoresist layer L2 may be exposed. In this case, the second area R2 of the second photoresist layer L2 may be exposed. The second area R2 is an area of the second photoresist layer L2 arranged on the upper surface LUS1 of the first bank layer BL1. The second area R2 may be an area of the second photoresist layer L2 not corresponding to the first area R1.

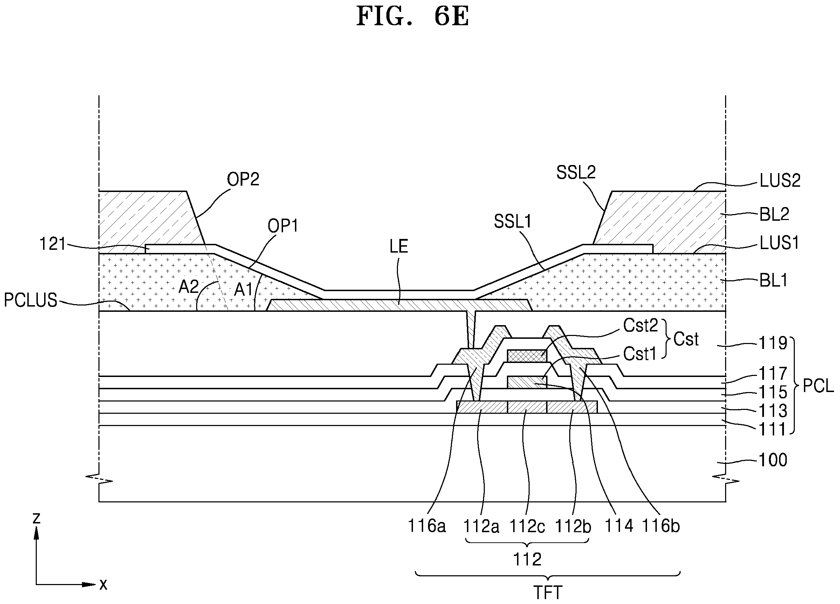

Referring to FIG. 6E, a portion of the second photoresist layer L2 may be removed through a developing process. The second photoresist layer L2 is formed by using a negative photoresist liquid. When a developing process is performed on the second photoresist layer L2, the light-exposed second area R2 of the second photoresist layer L2 may be removed. Therefore, a second opening OP2 may be formed in the second photoresist layer L2 to form a second bank layer BL2. In this case, the second opening OP2 may be formed on the first opening OP1. Therefore, the second opening OP2 may correspond to the first opening OP1.

The second bank layer BL2 may be formed to cover the end portion of the first electrode 121. That is, the second bank layer BL2 may be formed to cover the third electrode area E3 of the first electrode 121. In some embodiments, the second bank layer BL2 may have a thickness of about 500 nm or less.

The degree of adhesion with the first electrode 121 and/or the first bank layer BL1 may be increased through a curing and drying process of the second bank layer BL2. In this case, the curing and drying process may include a heat treatment process. Because the second bank layer BL2 includes a negative photoresist, the second bank layer BL2 may shrink more than the first bank layer BL1 including a positive photoresist. A second angle A2 between the upper surface PCLUS of the pixel circuit layer PCL or the upper surface of the substrate 100 and the inner surface SSL2 of the second bank layer BL2 may be about 60° or more. Therefore, the second angle A2 between the upper surface PCLUS of the pixel circuit layer PCL or the upper surface of the substrate 100 and the inner surface SSL2 of the second bank layer BL2 may be greater than the first angle A1 between the upper surface PCLUS of the pixel circuit layer PCL or the upper surface of the substrate 100 and the inner surface SSL1 of the first bank layer BL1.

The second bank layer BL2 may have liquid repellency. In this case, when a curing and drying process is performed on the second bank layer BL2, a liquid-repellent material or a hydrophobic material included in the second bank layer BL2 may float to the upper surface LUS2 of the second bank layer BL2. That is, the upper surface LUS2 of the second bank layer BL2 may have liquid repellency, and the inner surface SSL2 of the second bank layer BL2 may not have liquid repellency.

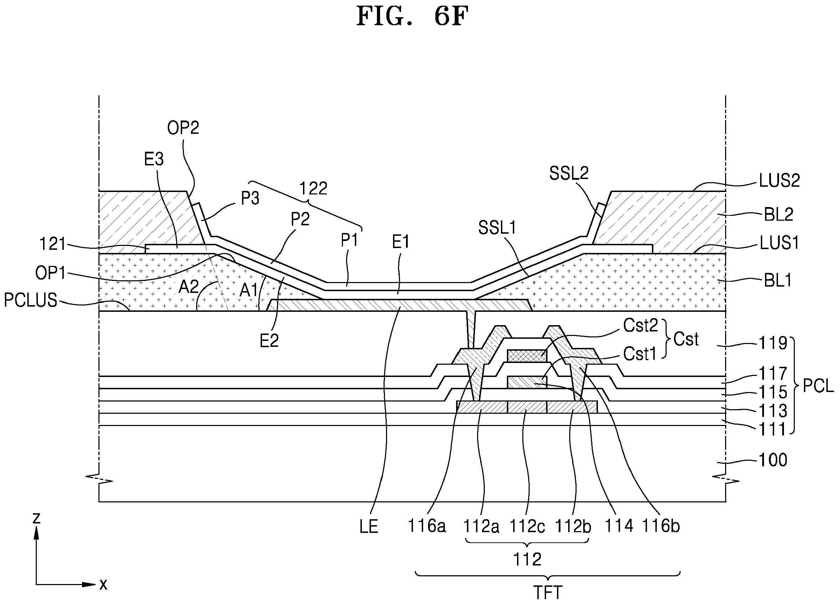

Referring to FIG. 6F, an emission layer 122 may be formed on the first electrode 121. On the first electrode 121, the emission layer 122 may be formed along the inner surface SSL1 of the first bank layer BL1. In some embodiments, the emission layer 122 may be further formed along the inner surface SSL2 of the second bank layer BL2. That is, a first emission layer area P1 may be formed on the first electrode area E1, and the second emission layer area P2 may be formed on the second electrode area E2. The third emission layer area P3 may be formed on the inner surface SSL2 of the second bank layer BL2. In some embodiments, the thickness of the third emission layer area P3 may be gradually reduced toward the edge of the third emission layer area P3.

The emission layer 122 may be formed by discharging ink including a light-emitting material onto the first electrode 121. For example, the emission layer 122 may be formed by inkjet printing. In this case, accurate alignment between an inkjet discharge port and the second opening OP2 may be required. When the alignment between the inkjet discharge port and the second opening OP2 is inaccurate, the emission layer 122 may also be formed on the upper surface LUS2 of the second bank layer BL2. Therefore, defective organic light-emitting diodes may be formed. In the illustrated embodiment, because the upper surface of the second bank layer BL2 has liquid repellency, the emission layer 122 may not be formed on the upper surface LUS2 of the second bank layer BL2 and may be formed in the first opening OP1 and/or the second opening OP2.

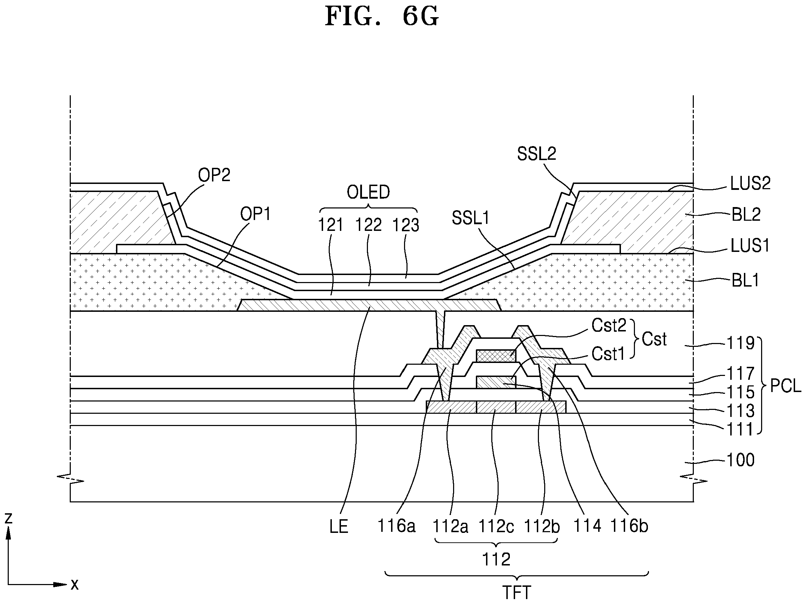

Referring to FIG. 6G, a second electrode 123 may be formed to cover the emission layer 122. The second electrode 123 may be formed to cover the emission layer 122 and the second bank layer BL2.

The first bank layer BL1 may be formed of a positive photoresist, and the second bank layer BL2 may be formed of a negative photoresist. Therefore, the first angle A1 may be less than the second angle A2, and on the first electrode 121, the emission layer 122 may be formed along the inner surface SSL1 of the first bank layer BL1. Alternatively, both the first bank layer BL1 and the second bank layer BL2 may be formed of a positive photoresist. When the first bank layer BL1 is formed of a negative photoresist, the first angle A1 formed by the inner surface SSL1 of the first bank layer BL1 becomes relatively greater than that when the first bank layer BL1 is formed of a positive type photoresist. Also, the inner surface SSL1 of the first bank layer BL1 does not have liquid repellency. When the first electrode 121 is not formed along the inner surface SSL1 of the first bank layer BL1, the thickness of the emission layer 122 may not be maintained constant on the inner surface SSL1 of the first bank layer BL1. That is, the thickness of the second emission layer area P2 may be greater than the thickness of the first emission layer area P1. When the thickness of the second emission layer area P2 is greater than the thickness of the first emission layer area P1, light may not be extracted from the second emission layer area P2. Therefore, the emission area of the organic light-emitting diode may be reduced. However, in the illustrated embodiment, because the thickness of the emission layer 122 may be maintained substantially constant, light may be extracted from the first emission layer area P1 and the second emission layer area P2, and the emission area may be expanded.

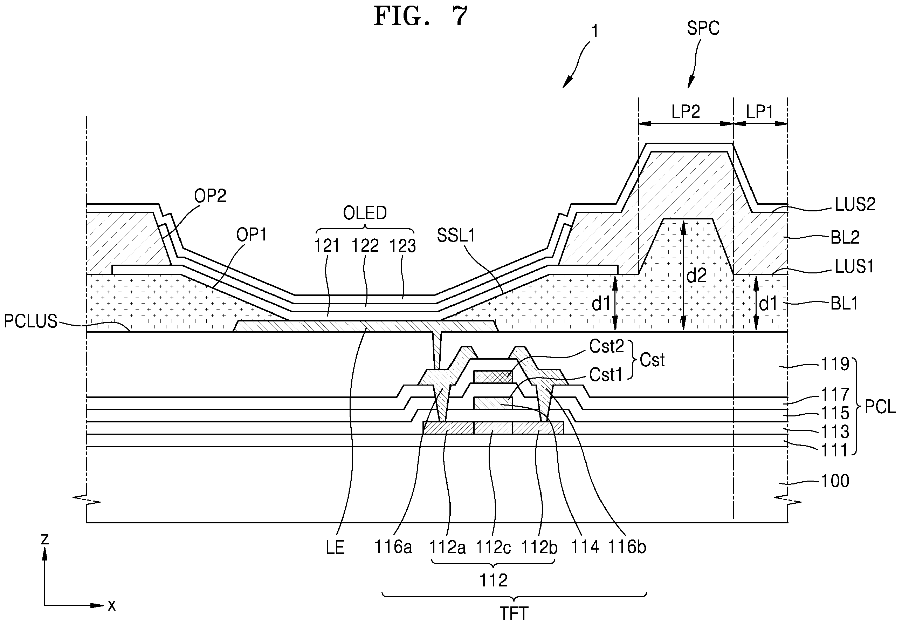

FIG. 7 is a cross-sectional view of a fourth embodiment of a display apparatus 1 constructed according to the principles of the invention. The embodiment of FIG. 7 is different from the embodiment of FIG. 4A in that the first bank layer BL1 includes a first bank area LP1 having a first thickness d1 and a second bank area LP2 having a second thickness d2. In FIG. 7, the same reference numerals as those in FIG. 4A refer to the same members, and a repetitive description will be omitted to avoid redundancy.

Referring to FIG. 7, the display apparatus 1 may include: a substrate 100; a pixel circuit layer PCL including a thin-film transistor TFT on the substrate 100; a first bank layer BL1 arranged on the pixel circuit layer PCL and including a first opening OP1; and an organic light-emitting diode OLED arranged to correspond to the first opening OP1 and including a first electrode 121, an emission layer 122, and a second electrode 123, which are sequentially stacked. The first electrode 121 may extend from an inner surface SSL1 of the first bank layer BL1 along an upper surface LUS1 of the first bank layer BL1, and on the first electrode 121, the emission layer 122 may extend along the inner surface SSL1 of the first bank layer BL1.

In the illustrated embodiment, the first bank layer BL1 may include a first bank area LP1 having a first thickness d1 and a second bank area LP2 having a second thickness d2. In this case, the first thickness d1 may be different from the second thickness d2. The second thickness d2 may be greater than the first thickness d1.

The first bank area LP1 and the second bank area LP2 may be spaced apart from the first opening OP1. That is, the first bank area LP1 and the second bank area LP2 may be spaced apart from the inner surface SSL1 of the first bank layer BL1.

In the illustrated embodiment, because the second thickness d2 of the second bank area LP2 is greater than the first thickness d1 of the first bank area LP1, the second bank area LP2 and the second bank layer BL2 may form a spacer SPC. Therefore, when the upper substrate is coupled or when a process using a mask is performed, it is possible to prevent the organic light-emitting diode OLED from being damaged.

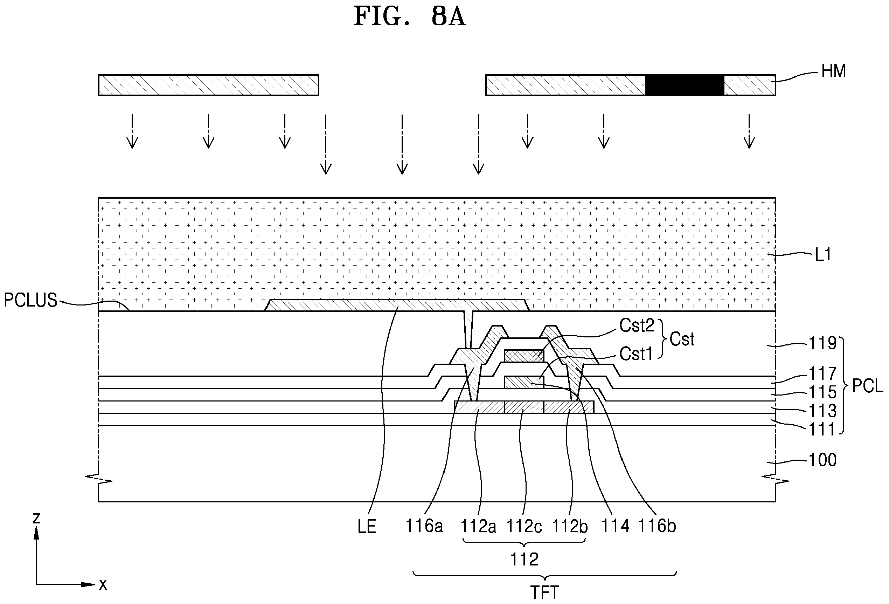

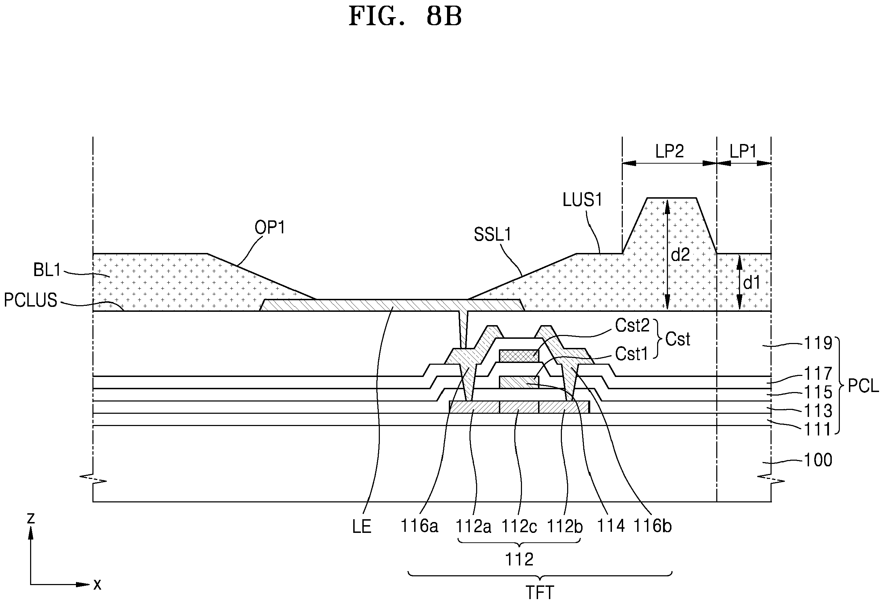

FIGS. 8A and 8B are cross-sectional views illustrating a method of manufacturing a display apparatus shown in FIG. 7. In FIGS. 8A and 8B, the same reference numerals as those in FIG. 6B refer to the same members, and the description will be omitted to avoid redundancy.

Referring to FIGS. 8A and 8B, a pixel circuit layer PCL including at least one thin-film transistor TFT may be formed on a substrate 100, and a first photoresist layer L1 may be formed on the pixel circuit layer PCL. The first photoresist layer L1 may include a positive photoresist.

A half-tone mask HM may be arranged on the first photoresist layer L1. The half-tone mask HM may control the amount of exposure applied to the first photoresist layer L1. For example, the half-tone mask HM may perform control such that the amount of exposure applied to the area in which the first bank area LP1 is to be formed is smaller than the amount of exposure applied to the area in which the first opening OP1 is to be formed. Also, the half-tone mask HM may perform control such that the amount of exposure applied to the second bank area LP2 is smaller than the amount of exposure applied to the area in which the first bank area LP1 is to be formed. In some embodiments, the half-tone mask HM may shield the second bank area LP2 from being light-exposed.

The first photoresist layer L1 may be light-exposed and removed through a developing process. Therefore, a first opening OP1, a first bank area LP1, and a second bank area LP2 may be formed in the first photoresist layer L1. The first opening OP1, the first bank area LP1, and the second bank area LP2 may be simultaneously formed.

In the illustrated embodiment, because the first photoresist layer L1 includes a positive photoresist, the first opening OP1, the first bank area LP1, and the second bank are LP2 may be simultaneously formed by using the half-tone mask HM.

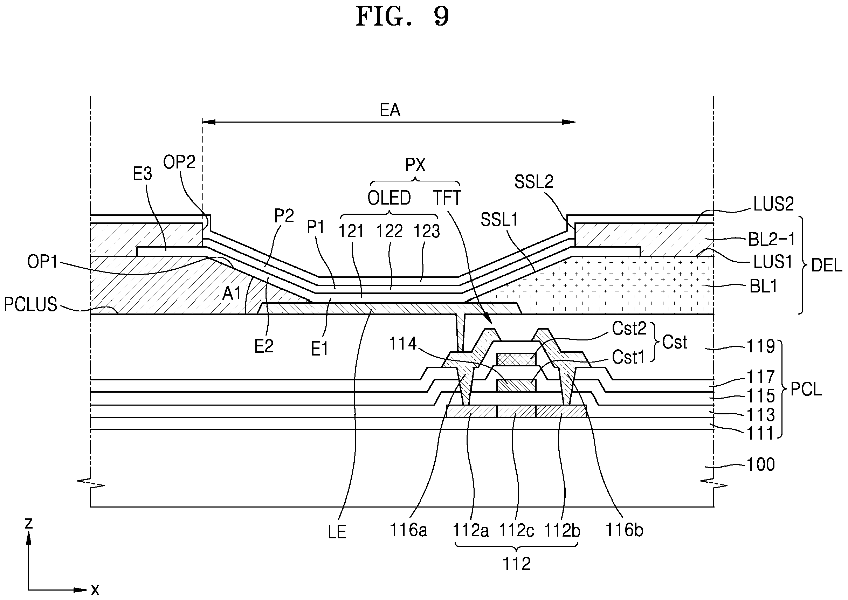

FIG. 9 is a cross-sectional view of a fifth embodiment of a display apparatus constructed according to the principles of the invention. The embodiment of FIG. 9 is different from the embodiment of FIG. 4A in that the second bank layer BL2-1 includes a fluorine resin or an organic material having an unsaturated bond and fluorine. In FIG. 9, the same reference numerals as those in FIG. 4A refer to the same members, and a repetitive description will be omitted to avoid redundancy.

Referring to FIG. 9, the display apparatus may include: a substrate 100; a pixel circuit layer PCL including a thin-film transistor TFT on the substrate 100; a first bank layer BL1 arranged on the pixel circuit layer PCL and including a first opening OP1; and an organic light-emitting diode OLED arranged to correspond to the first opening OP1 and including a first electrode 121, an emission layer 122, and a second electrode 123, which are sequentially stacked. The first electrode 121 may extend from an inner surface SSL1 of the first bank layer BL1 along an upper surface LUS1 of the first bank layer BL1, and on the first electrode 121, the emission layer 122 may extend along the inner surface SSL1 of the first bank layer BL1.

In the illustrated embodiment, a second bank layer BL2-1 may be arranged on the first bank layer BL1. In this case, the second bank layer BL2-1 may cover the end portion of the first electrode 121. Therefore, the first electrode 121 may extend between the first bank layer BL1 and the second bank layer BL2-1. The second bank layer BL2-1 may include a fluorine resin. For example, the second bank layer BL2-1 may include an organic material having an unsaturated bond and a fluoro group. Alternatively, the second bank layer BL2-1 may include an organic material having an unsaturated bond and fluorine. The fluoro group or fluorine included on the surface of the second bank layer BL2-1 may improve the repellency of the surface of the second bank layer BL2-1.

The emission layer 122 may be arranged on the first electrode 121. The emission layer 122 may include a first emission layer area P1 and a second emission layer area P2. The first emission layer area P1 may be arranged on the first electrode area E1. The second emission layer area P2 may be arranged on the second electrode area E2. That is, the second emission layer area P2 may be arranged on the inner surface SSL1 of the first bank layer BL1. In the illustrated embodiment, because the surface of the second bank layer BL2-1 includes the fluoro group or fluorine, the surface of the second bank layer BL2-1 may have liquid repellency. Therefore, the emission layer 122 may be arranged inside the second opening OP2.

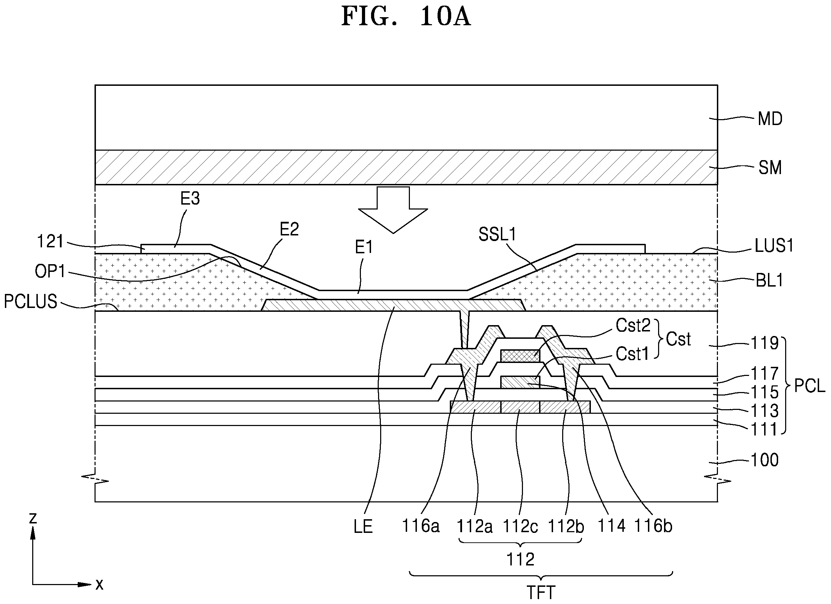

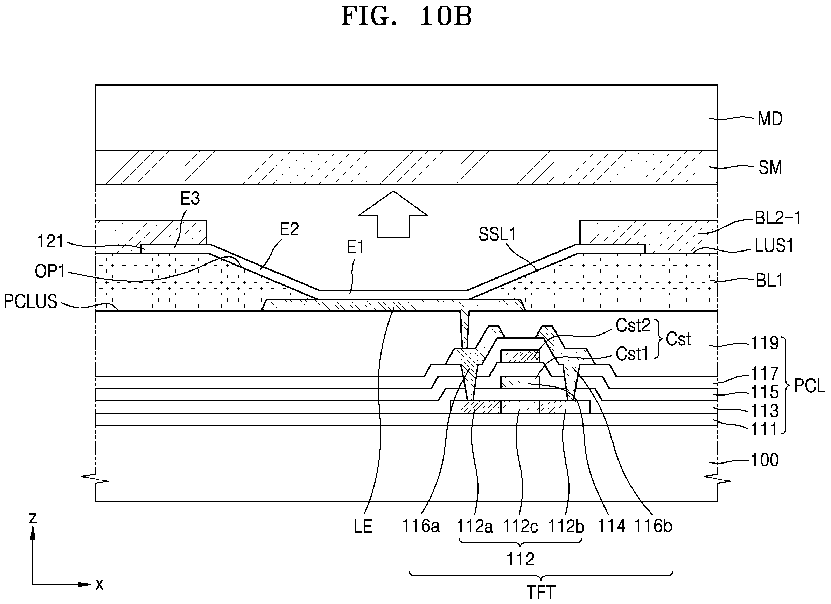

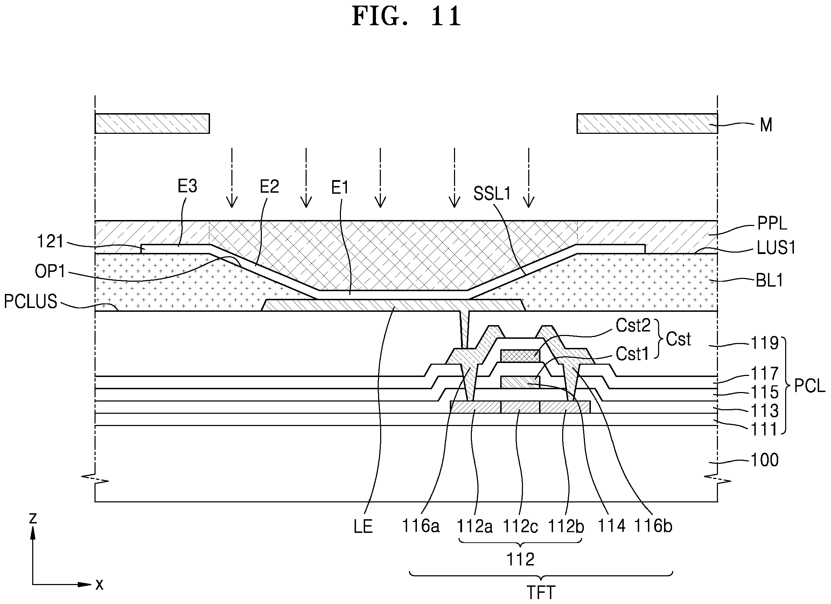

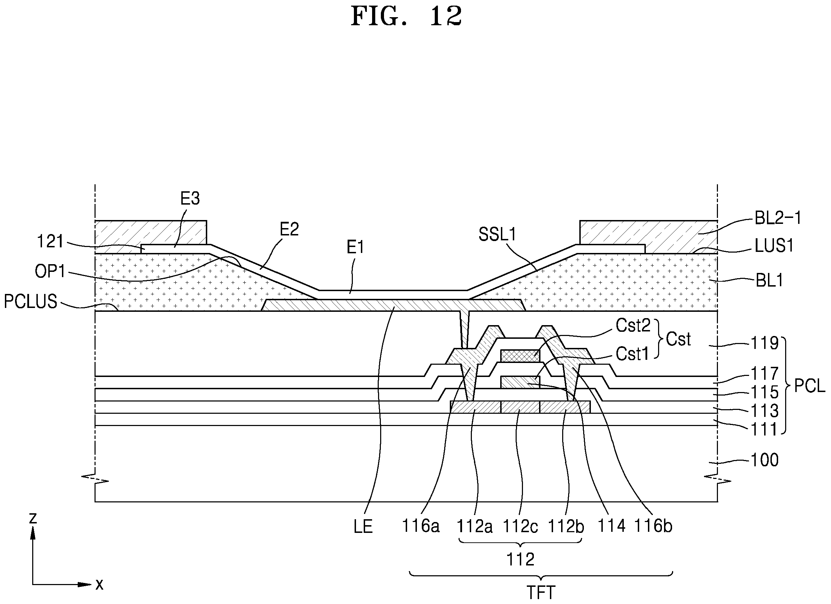

FIGS. 10A and 10B are cross-sectional views of a method of manufacturing a display apparatus shown in FIG. 9. FIGS. 11 and 12 are cross-sectional views of another method of manufacturing a display apparatus shown in FIG. 9.

Referring to FIGS. 10A, 10B, 11, and 12, a pixel circuit layer PCL including at least one thin-film transistor TFT may be formed on a substrate 100. A first bank layer BL1 including a first opening OP1 may be formed on the pixel circuit layer PCL, and a first electrode 121 may be formed to overlap the first opening OP1. Because the method of forming the first bank layer BL1 and the first electrode 121 is similar to that described with reference to FIGS. 6A to 6D, a detailed description will be omitted to avoid redundancy.

In the illustrated embodiment, referring to FIG. 10A, a second bank layer BL2-1 including a fluoro group or fluorine may be formed on the first bank layer BL1. Specifically, a molding material SM may be heated and fluidized, and the molding material SM may be provided to a mold MD. The molding material SM may include a fluorine resin. For example, the molding material SM may include an organic material having an unsaturated bond and a fluoro group. Alternatively, the molding material SM may include an organic material having an unsaturated bond and fluorine. The mold MD may include a polymer copolymer. For example, the mold MD may include dimethylsiloxane and aminopropylmethylsiloxane copolymer (PDMS-co-APMS) or polydimethylsiloxane (PDMS).

Referring to FIG. 10B, the molding material SM may be extruded on the upper surface LUS1 of the first bank layer BL1. Therefore, the second bank layer BL2-1 may be formed on the upper surface LUS1 of the first bank layer BL1.

Alternatively, referring to FIGS. 11 and 12, a preliminary layer PPL may be formed on the first bank layer BL1 and the first electrode 121. The preliminary layer PPL may include a fluorine resin. For example, the preliminary layer PPL may include an organic material having an unsaturated bond and a fluoro group. Alternatively, the preliminary layer PPL may include an organic material having an unsaturated bond and fluorine.

The mask M may be arranged on the preliminary layer PPL. An opening of the mask M may overlap the first opening OP1.

The preliminary layer PPL may be irradiated with an excimer laser. The excimer laser may be a laser having an ultraviolet wavelength range. For example, the excimer laser may include a KrF excimer laser having a wavelength of about 248 nm. However, the disclosure is not limited thereto.

The preliminary layer PPL may be irradiated with the excimer laser through the opening of the mask M, and the excimer laser may ablate an area of the preliminary layer PPL corresponding to the first opening OP1. Therefore, the second bank layer BL2-1 may be formed.

In some embodiments, when the preliminary layer PPL is irradiated with the excimer laser, at least one of oxygen and ozone may be supplied. At this time, when the preliminary layer PPL is irradiated with laser, at least one of oxygen and ozone is radicalized and a portion of the preliminary layer PPL may be ablated.

Specifically, at least one of oxygen and ozone may be supplied to correspond to the first electrode 121. When the preliminary layer PPL is irradiated with ultraviolet light, at least one of oxygen and ozone is radicalized and the radical may react with the fluorine resin. Therefore, the fluorine resin formed on a portion of the preliminary layer PPL, that is, the upper surface of the first electrode 121 may be removed. In the illustrated embodiment, the preliminary layer PPL formed on the upper surface of the first electrode 121 may be ablated, and the emission layer may be uniformly formed on the first electrode 121. Also, a hydroxyl group (-OH) may be formed on the upper surface of the first electrode 121. Therefore, the upper surface of the first electrode 121 may have lyophilicity or hydrophilicity with respect to the ink including the light-emitting material, and the emission layer may be uniformly formed on the first electrode 121.

In display apparatus constructed according to the principles and embodiments of the invention, the first electrode extends from the inner surface of the first bank layer along the upper surface of the first bank layer, and on the first electrode, the emission layer extends along the inner surface of the first bank layer, such that the visibility and the lifetime of the display element is improved.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A display apparatus comprising:
a substrate;
a pixel circuit layer having at least one thin-film transistor on the substrate;
a first layer disposed on the pixel circuit layer and having a first opening; and
a display element disposed in the first opening and having a first electrode, an emission layer, and a second electrode, which are sequentially stacked,
wherein the first electrode extends from an inner surface of the first layer defining the first opening along an upper surface of the first layer, and
the emission layer extends on the first electrode along the inner surface of the first layer.

2. A display apparatus of claim 1, further comprising a second layer covering an end portion of the first electrode and having a second opening overlapping the first opening,
wherein the second layer has an inner surface defining the second opening, and
a first angle between the upper surface of the substrate and the inner surface of the first layer is smaller than a second angle between an upper surface of the substrate and the inner surface of the second layer.

3. A display apparatus of claim 2, wherein the first electrode extends between the first layer and the second layer.

4. A display apparatus of claim 2 or claim 3, wherein the emission layer extends along the inner surface of the second layer.

5. A display apparatus of any one of claims 2 to 4, wherein an upper surface of the second layer has liquid repellency.

6. A display apparatus of any one of claims 2 to 5, wherein:
(i) the second layer comprises a fluorine resin; or
(ii) the second layer comprises a negative photoresist, and
the first layer comprises a positive photoresist.

7. A display apparatus of any one of claims 2 to 6, wherein the second electrode covers the emission layer and the second layer, optionally wherein, the second electrode extends on the emission layer along the inner surface of the first layer.

8. A display apparatus of any one of claims 1 to 7, wherein the first angle between the upper surface of the substrate and the inner surface of the first layer is about 30° or less.

9. A display apparatus of any one of claims 1 to 8, further comprising a connection electrode between the pixel circuit layer and the display element,
wherein the first electrode is electrically connected to the connection electrode.

10. A display apparatus of any one of claims 1 to 8, wherein the first layer comprises a first bank layer having a connection opening spaced apart from the first opening,
the pixel circuit layer further comprises a planarization layer covering the at least one thin-film transistor and comprising a contact hole exposing the at least one thin-film transistor, and
the connection opening is connected to the contact hole, optionally wherein the first electrode extends from the upper surface of the first bank layer to the connection opening.

11. A display apparatus of any one of claims 1 to 10, wherein the first layer comprises a first area having a first thickness, and
a second area having a second thickness different from the first thickness.

12. A display apparatus according to claim 1, further comprising:
a second layer covering an end portion of the first electrode and having a second opening corresponding to the first opening, and
wherein a first angle between the inner surface of the first layer and an upper surface of the substrate is about 30° or less, and
the second electrode covers the emission layer and the second layer.

13. A display apparatus of claim 12, wherein:
(i) the first electrode extends between the first layer and the second layer; and/or
(ii) the second layer comprises a second bank layer having an inner surface defining the second opening, and
a second angle between the upper surface of the substrate and the inner surface of the second bank layer is greater than the first angle; and/or
(iii) the first layer comprises a positive photoresist, and
the second layer comprises a fluorine resin or a negative photoresist; and/or
(iv) an upper surface of the second layer has liquid repellency.

14. A method of manufacturing a display apparatus, the method comprising the steps of:
forming a pixel circuit layer having at least one thin-film transistor on the substrate;
forming a first layer on the pixel circuit layer, the first layer having a first opening;
forming a first electrode in the first opening;
forming a second layer on the first layer, the second layer having a second opening; and
forming an emission layer by discharging ink including a light-emitting material onto the first electrode,
wherein an upper surface of the second layer has liquid repellency.

15. A method of claim 14, wherein the step of forming the first layer comprises the steps of:
forming a first photoresist layer on the pixel circuit layer;
light-exposing a first area of the first photoresist layer; and
forming the first opening in the first area, and
wherein the step of forming the second layer comprises the steps of:
forming a second photoresist layer on the first layer and the first electrode;
light-exposing a second area of the second photoresist layer arranged on an upper surface of the first layer; and
forming the second opening on the first opening.

16. A method of claim 14 or claim 15, wherein the first layer comprises a first bank layer having an inner surface defining the first opening,
the second layer comprises a second bank layer having an inner surface defining the second opening, and
a first angle between the upper surface of the substrate and the inner surface of the first bank layer is smaller than a second angle between an upper surface of the substrate and the inner surface of the second bank layer.

17. A method of claim 16, wherein:
(i) in the step of forming the first electrode, the first electrode extends from the inner surface of the first bank layer to an upper surface of the first bank layer; and/or
(ii) in the step of forming the emission layer, the emission layer is formed on the first electrode along the inner surface of the first bank layer.

18. A method of claim 14, wherein:
(i) the step of forming the second layer comprises the steps of:
providing a molding material including a fluorine resin to a mold; and
extruding the molding material on an upper surface of the first layer; or
(ii) the step of forming the second layer comprises the steps of:
forming a preliminary layer including a fluorine resin on the first electrode and the first layer, and
irradiating the preliminary layer with an excimer laser.

19. A method of any one of claims 14 to 18, wherein:
(i) the method further comprises the step of forming a second electrode covering the emission layer and the second layer; and/or
(ii) the step of forming the first layer comprises the steps of:
forming a first area having a first thickness; and
forming a second area having a second thickness different from the first thickness; and/or
(iii) the method further comprises the step of supplying at least one of oxygen and ozone to the first electrode.
